# EUROPÄISCHE PATENTANMELDUNG

(11) **EP 2 728 219 A1**
(43) Veröffentlichungstag der Anmeldung: **07.05.2014**
(21) Anmeldenummer: 12191390.9
(22) Anmeldetag: 06.11.2012
(51) Int. Cl.: F16F 15/00, G03F 7/20

(54) **Verfahren zur Postionierung eines aktiv schwingungsisoliert gelagerten Bauteils sowie Schwingungsisolationssystem**

(71) Anmelder: Integrated Dynamics Engineering GmbH, 65479 Raunheim (DE)
(72) Erfinder: Kappel, Roland, 65195 Wiesbaden (DE)
(74) Vertreter: Blumbach Zinngrebe

(57) **Zusammenfassung**

Die Erfindung betrifft ein Schwingungsisolationssystem (1) sowie ein Verfahren zur Positionierung eines aktiv schwingungsgelagerten Bauteils, wobei die Position des Bauteils über Positionssensoren (8,9) bestimmt wird. Gemäß der Erfindung ist zwischen den Positionssensoren (8,9) ein weiterer Positionssensor (8,9) angeordnet, der jeweils einen Positionssensor (8,9) bei dessen Austausch ersetzt.

## Beschreibung

### Gebiet der Erfindung

Die Erfindung betrifft ein Schwingungsisolationssystem sowie ein Verfahren zur Positionierung eines aktiv schwingungsisoliert gelagerten Bauteils. Insbesondere bezieht sich die Erfindung auf Schwingungsisolationssysteme, wie sie in der Lithographie verwendet werden.

### Hintergrund der Erfindung

Schwingungsisolationssysteme für die Aufnahme lithographischer Geräte zur Herstellung von Halbleiterbauelementen sind insbesondere als aktive Schwingungsisolationssysteme ausgebildet, bei welcher die Position eines schwingungsisoliert gelagerten Tisches mittels Sensoren erfasst wird und möglichen Schwingungen aktiv entgegen gesteuert wird. Das aktive Gegensteuern kann insbesondere durch Ansteuern von Luftlagern, auf denen der Tisch gelagert ist, sowie durch Ansteuern von Aktoren, insbesondere von Magnetaktoren, erfolgen.

Ein typisches Schwingungsisolationssystem umfasst einen sogenannten Baseframe, der auf dem Boden stehend den weiteren Aufbau des Schwingungsisolationssystems trägt. Insbesondere sind Schwingungsisolatoren wie beispielsweise Luftlager an dem Baseframe angebracht und mit einem schwingungsisoliert gelagerten Tisch, welcher auch Metroframe genannt wird, verbunden. Dieser Tisch trägt die zu isolierende Baugruppe.

In vielen Fällen wird gefordert, dass der Tisch beziehungsweise Metroframe gegenüber dem Baseframe beziehungsweise der Basis eine definierte, reproduzierbare Position hat. Dies soll insbesondere auch dann sicher gestellt sein, nachdem Teile der Lagerung des Tisches ausgebaut wurden.

Es sind weiter Schwingungsisolationssysteme bekannt, bei denen ein Positionssensor und ein Lager jeweils eine Baugruppe bilden.

Wird nun eine Baugruppe ausgetauscht, welche einen Sensor umfasst, kann es beim Wiedereinbau der Baugruppe beziehungsweise beim Einbau einer neuen Baugruppe, welche den Sensor umfasst, zu einer Positionsverschiebung des Tisches zumindest an der Position des ausgebauten Lagers relativ zur Basis im Mikrometerbereich kommen.

Um dennoch die Position des Tisches zur Basis exakt einzustellen, kann die Basis mit einem Messsystem versehen werden, mittels dessen die Position des Tisches genau bestimmt werden kann. Ein derartiges Messsystem muss aber, um Positionsänderungen am Ort des jeweiligen Sensors beziehungsweise der jeweiligen Baugruppe erfassen zu können, die Position des Tisches in sechs Freiheitsgraden messen. Mithin ist ein derartiges Messsystem aufwendig.

Um die Bereitstellung eines derartigen aufwendigen Messsystems zu verhindern, wird in der Praxis ferner versucht, die Fertigungstolleranzen derart gering zu halten, dass auch beim Austausch einer Sensor/Aktor-Baugruppe eine hinreichend genaue räumliche Position der Bauteile gegeben ist. Auch diese Vorgehensweise ist recht aufwendig und führt in vielen Fällen nicht zum gewünschten Erfolg.

### Aufgabe der Erfindung

Die Erfindung liegt demgegenüber die Aufgabe zu Grunde die genannten Nachteile des Standes der Technik zu reduzieren.

Es ist insbesondere eine Aufgabe der Erfindung ein einfaches Verfahren zur Positionierung eines aktiv schwingungsisoliert gelagerten Bauteils bereit zu stellen, welches eine exakte reproduzierbare Positionierung des Bauteiles nach dem Austausch einer Sensorbaugruppe ermöglicht.

### Zusammenfassung der Erfindung

Die Aufgabe der Erfindung wird bereits durch ein Schwingungsisolationssystem sowie durch ein Verfahren zur Positionierung eines aktivschwingungsisoliert gelagerten Bauteiles nach einem der unabhängigen Ansprüche gelöst. Bevorzugte Ausführungsformen und Weiterbildungen der Erfindung sind den jeweiligen Unteransprüchen zu entnehmen.

Die Erfindung betrifft ein Schwingungsisolationssystem, welches eine Basis sowie einen auf der Basis aktiv schwingungsisoliert gelagerten Tisch umfasst.

Unter einer Basis wird ein beliebiges Bauteil beziehungsweise eine beliebige Baugruppe verstanden, welche auf dem Boden steht und in der Regel auch als Baseframe bezeichnet wird.

Auf der Basis ruht ein ausgebildeter Tisch, welcher der Aufnahme der schwingungsisoliert gelagerten Komponenten, wie beispielsweise Lithographiegeräten, dient.

Es versteht sich, dass im Sinne der Erfindung der Tisch nicht notwendigerweise eine Platte umfassen muss, sondern der Tisch kann beliebig gestaltet sein, insbesondere auch als Rahmen und wird auch als Metroframe bezeichnet.

Zwischen Basis und Tisch sind aktive Schwingungsisolatoren angeordnet.

Derartige aktive Schwingungsisolatoren können insbesondere Luftlager umfassen. Typischerweise umfassen Lager zur aktiven Schwingungsisolation auch Aktoren, insbesondere Magnetaktoren, Piezoaktoren oder elektrostatische Aktoren, mittels derer Schwingungen aktiv entgegen gewirkt werden kann.

Den aktiven Schwingungsisolatoren ist jeweils ein Positionssensor zugeordnet.

Unter einem zugeordneten Positionssensor wird ein Sensor verstanden, mittels dessen die Position des Tisches, am oder in der Nähe des aktiven Lagers, erfasst werden kann. Es ist insbesondere vorgesehen, dass die aktiven Schwingungsisolatoren mit dem zugeordneten Positionssensoren jeweils als eine austauschbare Baugruppe ausgebildet sind.

So ist es insbesondere bekannt, Positionssensoren an oder in einem Luftlager anzubringen.

Als Sensoren kommen insbesondere Magnet- oder Piezosensoren in Betracht.

Mittels der Positionssensoren wird vorzugsweise die Position des Tisches an zumindest drei Stellen erfasst.

Gemäß der Erfindung ist zwischen zumindest zwei Schwingungsisolatoren ein weiterer Positionssensor angeordnet.

Vorzugsweise ist dieser weitere Positionssensor an der Basis befestigt.

Mittels des weiteren Positionssensors kann die Position des Tisches gegenüber der Basis derart überbestimmt sein, dass die Position des Tisches am Ort der Schwingungsisolatoren auch ohne jeweils einen der Postitionssensoren bestimmt werden kann, welche den Schwingungsisolatoren zugeordnet sind.

Fällt nunmehr ein den Schwingungsisolatoren zugeordneter Sensor aus oder wird dieser ausgetauscht, kann weiterhin die Position am Ort dieses Sensors über den zwischen den Schwingungsisolatoren angeordneten Positionssensor hinreichend bestimmt werden.

Die Erfindung ermöglicht so auf sehr einfache Weise den Austausch einer Sensorbaugruppe, wobei die Position des Tisches am Ort der Sensorbaugruppe weiterhin über den zusätzlichen weiteren Positionssensor und die verbleibenden Positionssensoren bestimmt werden kann.

Der weitere Positionssensor ersetzt den ausgetauschten Positionssensors. Da die verbleibenden Positionssensoren weiter zur Bestimmung der Position des Tisches verwendet werden können ist nicht erforderlich, dass ein Sensor verwendet wird, der in allen sechs Freiheitsgraden Positionsänderungen des Tisches erfasst.

Die mithilfe des weiteren Sensors bestimmte Position kann sodann verwendet werden, um eine neueingebaute Sensorbaugruppe zu kalibrieren. Nach Kalibrierung der neu eingebauten Sensorbaugruppe ist das System wieder überbestimmt, derart dass beispielsweise ein weiterer, einem Schwingungsisolator zugeordneter Positionssensor ausgetauscht werden kann.

Die Erfindung ermöglicht also den Verzicht auf ein aufwendiges Messsystem an der Basis, welches unabhängig von den weiteren Sensoren in drei Freiheitsgraden misst.

Vielmehr genügt in der Regel ein als Zwei-Achsen wirksamer Positionssensor.

Der weitere Positionssensor entspricht vorzugsweise den Positionssenoren, welche den Schwingungsisolatoren zugeordnet sind.

Insbesondere ist der weitere Positionssensor in der oder den selben Raumrichtungen wirksam und basiert auf dem selben Messsystem, wie die dem Schwingungsisolatoren zugeordneten Sensoren.

Die Erfindung betrifft des Weiteren ein Verfahren zur Positionierung eines aktiv schwingungsisoliert gelagerten Bauteiles. Insbesondere betrifft das Verfahren die Positionierung eines schwingungsisoliert gelagerten Tisches.

Die Position des Bauteiles wird über Positionssensoren bestimmt.

Gemäß der Erfindung wird mittels eines weiteren Positionssensors die Position des Bauteils derart überbestimmt, dass die Position des Bauteiles auch ohne einen der Positionssensoren bestimmt werden kann.

Nach einem Austausch eines der Positionssensoren wird über den weiteren Positionssensor sowie die verbliebenen nicht ausgetauschten Positionssensoren die Position des Bauteiles an der Stelle des ausgetauschten Positionssensors bestimmt beziehungsweise berechnet.

Sodann kann der ausgetauschte Positionssensor mittels des weiteren Positionssensors kalibriert werden.

### Beschreibung der Zeichnungen

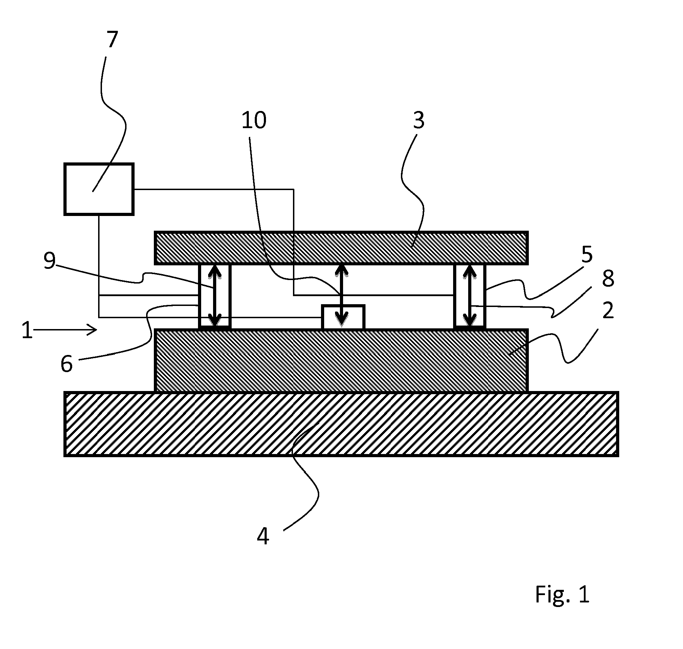

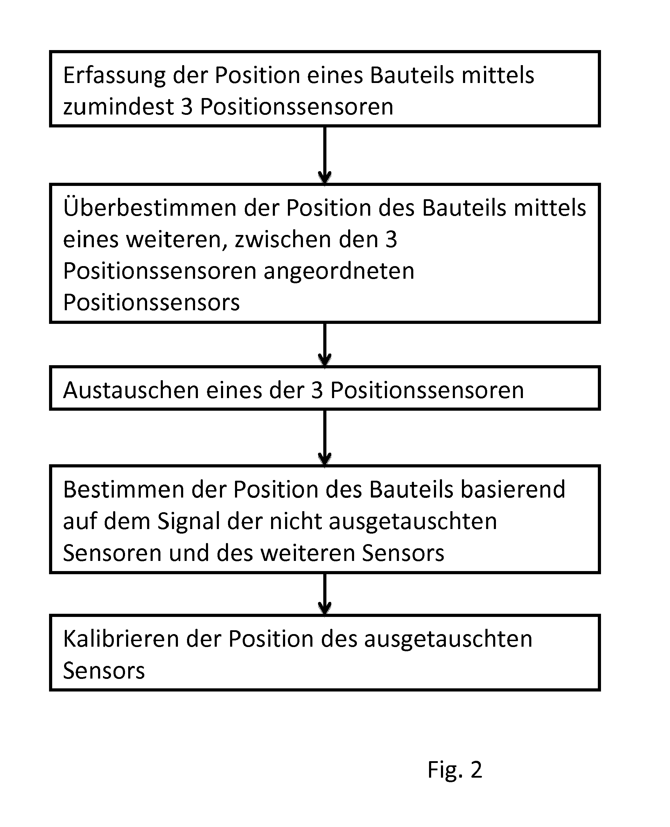

Die Erfindung soll im Folgenden Bezug nehmend auf ein schematisch dargestelltes Ausführungsbeispiels anhand der Zeichnungen Fig. 1 und Fig. 2 näher erläutert werden.

Fig. 1 zeigt eine schematische Ansicht eines Schwingungsisolationssystems 1.

Das Schwingungsisolationssystem 1 umfasst eine auf dem Boden 4 angeordnete Basis 2.

Die Basis 2 wird auch als Baseframe bezeichnet.

Auf der Basis 2 ist ein Tisch 3, auch als Metroframe bezeichnet, aktiv schwingungsisoliert gelagert.

Hierzu sind zwischen Basis 2 und Tisch 3 Schwingungsisolatoren 5, 6 angeordnet.

Die Schwingungsisolatoren 5, 6 können beispielsweise ein Luftlager sowie Aktoren (nicht dargestellt) zur aktiven Schwingungsisolation umfassen.

In diesem Ausführungsbeispiel sind die Schwingungsisolatoren 5, 6 mit jeweils einem Positionssensor 8, 9 als eine Baugruppe ausgebildet.

Die Positionssensoren 8, 9 sind mit einem Controller 7 verbunden.

Über den Controller 7 werden Schwingungen erfasst und Signale zur aktiven Gegensteuerung errechnet.

Hierzu kann der Controller beispielsweise die Luftlager oder weitere, hier nicht dargestellte Aktoren zur aktiven Schwingungsisolation ansteuern.

Zusätzlich zu den den Schwingungsisolatoren 5, 6 zugeordneten Positionssensoren 8, 9 ist an der Basis 2 des Schwingungsisolationssystems zwischen den Schwingungsisolatoren 5, 6 ein weiterer Positionssensor 10 angeordnet.

Der weitere Positionssensor 10 ist als Zwei-Achsen Sensorsystem ausgebildet und kann aufgrund seiner räumlichen Position zwischen den Positionssensoren 5 und 6 jeweils einen dieser Positionssensoren ersetzen, wenn dieser beispielsweise ausgetauscht wird.

Es versteht sich, dass die hier dargestellte schematische Darstellung das System zweidimensional wiedergibt. Ein Schwingungsisolationssystem ist aber mit zumindest drei Schwingungsisolatoren versehen, zwischen welchen der weitere Positionssensor 10 angeordnet ist.

Der weitere Positionssensor 10 sollte von den Schwingungsisolatoren 5, 6 vorzugsweise im Wesentlichen gleichweit beabstandet sein.

Zumindest sollte aber der Abstand des Positionssensors 10 gegenüber dem räumlich nächsten Schwingungsisolator maximal die Hälfte des Abstandes zum am Weitesten entfernten Schwingungsisolator betragen.

Fig. 2 zeigt anhand eines Flussbildes die wesentlichen Verfahrensschritte zur Positionierung eines Bauteiles gemäß eines Ausführungsbeispieles der Erfindung.

Die Position eines Bauteiles, insbesondere eines schwingungsisoliert gelagerten Tisches, wird mittels zumindest drei Positionssensoren erfasst. Diese Positionssensoren sind den Schwingungsisolatoren zugeordnet und bilden insbesondere eine Baugruppe mit jeweils einem Schwingungsisolator.

Mittels eines Weiteren, zwischen den zumindest drei Positionssensoren angeordneten Positionssensors, wird die Position des Bauteiles an der Stelle eines jeden der drei Positionssensoren in zumindest einer Raumrichtung überbestimmt.

Es wird nunmehr einer der zumindest drei Positionssensoren ausgetauscht und die Position des Bauteiles an der Stelle des ausgetauschten Sensors, basierend auf dem Signal der nicht ausgetauschten Sensoren und des weiteren Sensors bestimmt.

Der weitere Sensor ersetzt nunmehr den ausgetauschten Sensor.

Da der weitere Sensor zwischen den zumindest drei Sensoren liegt, genügt die Verwendung eines einzigen Sensors, um wahlweise jeweils einen beliebigen der drei Positionssensoren zu ersetzen.

Auf Basis der über den weiteren Sensor bestimmten Position an der Stelle des ausgetauschten Sensors kann nunmehr die Position des ausgetauschten Sensors kalibriert werden.

Durch die Erfindung kann die Position eines Metroframes gegenüber einem Baseframe auch nach dem Austausch der einen Positionssensor umfassenden Baugruppe auf sehr einfache Weise bestimmt werden.

Insbesondere kann auf ein aufwendiges Messsystem für sechs Freiheitsgrade verzichtet werden.

## Patentansprüche

1. Schwingungsisolationssystem (1), umfassend eine Basis (2) sowie einen auf der Basis (2) aktiv schwingungsisoliert gelagerten Tisch (3), wobei zwischen Basis (2) und Tisch (3) aktive Schwingungsisolatoren (5,6) angeordnet sind, denen jeweils ein Positionssensor (8,9) zugeordnet ist, **dadurch gekennzeichnet, dass** zwischen zumindest zwei Schwingungsisolatoren (5,6) ein weiterer Positionssensor (10) angeordnet ist.

2. Schwingungsisolationssystem nach dem vorstehenden Anspruch, **dadurch gekennzeichnet, dass** über den weiteren Positionssensor (10) die Position des Tisches (3) gegenüber der Basis (2) überbestimmt ist.

3. Schwingungsisolationssystem nach dem vorstehenden Anspruch, **dadurch gekennzeichnet, dass** der weitere Positionssensor (10) an der Basis (2) befestigt ist.

4. Schwingungsisolationssystem nach dem vorstehenden Anspruch, **dadurch gekennzeichnet, dass** die aktiven Schwingungsisolatoren (5,6) mit den zugeordneten Positionssensoren (8,9) jeweils als eine austauschbare Baugruppe ausgebildet sind.

5. Schwingungsisolationssystem nach dem vorstehenden Anspruch, **dadurch gekennzeichnet, dass** der weitere Positionssensor (10) als ein in zwei Achsen wirksamer Positionssensor ausgebildet ist.

6. Schwingungsisolationssystem nach einem der vorstehenden Ansprüche, **dadurch gekennzeichnet, dass** der weitere Positionssensor (10) in derselben Raumrichtung wirksam ist wie die den Schwingungsisolatoren zugeordneten Positionssensoren (8,9).

7. Schwingungsisolationssystem nach einem der vorstehenden Ansprüche, **dadurch gekennzeichnet, dass** der weitere Positionssensor (10) auf demselben Messsystem basiert wie die den Schwingungsisolatoren (5,6) zugeordneten Positionssensoren (8,9).

8. Schwingungsisolationssystem nach einem der vorstehenden Ansprüche, **dadurch gekennzeichnet, dass** die den Schwingungsisolatoren zugeordneten Positionssensoren (8,9) und/oder der weitere Positionssensor (10) als Beschleunigungssensor ausgebildet ist.

9. Schwingungsisolationssystem nach einem der vorstehenden Ansprüche, **dadurch gekennzeichnet, dass** der weitere Positionssensor (10) von dem räumlich nächsten den Schwingungsisolatoren zugeordneten Positionssensor (8,9) höchstens halb so weit beabstandet ist wie vom räumlich am weitesten entfernten den Schwingungsisolatoren zugeordneten Positionssensor (8,9).

10. Schwingungsisolationssystem nach einem der vorstehenden Ansprüche, **dadurch gekennzeichnet, dass** der Tisch (3) zur Aufnahme eines Lithographiegerätes ausgebildet ist.

11. Schwingungsisolationssystem nach einem der vorstehenden Ansprüche, **dadurch gekennzeichnet, dass** die den Schwingungsisolatoren zugeordneten Positionssensoren (8,9) und der weitere Positionssensor (10) mit einem Controller (7) verbunden sind, wobei beim Entfernen eines den Schwingungsisolatoren zugeordneten Positionssensors (8,9) der Controller die Position des Tisches (3) auf Basis des Signals des weiteren Positionssensors und der Signale der verbleibenden den Schwingungsisolatoren zugeordneten Positionssensoren (8,9) bestimmt.

12. Verfahren zur Positionierung eines aktiv schwingungsisoliert gelagerten Bauteils, insbesondere eines schwingungsisoliert gelagerten Tisches (3) nach einem der vorstehenden Ansprüche, wobei die Position des Bauteils über Positionssensoren (8,9) bestimmt wird, **dadurch gekennzeichnet, dass** mittels eines weiteren Positionssensors (10) die Position des Bauteils derart überbestimmt wird, dass die Position des Bauteils auch ohne einen der Positionssensoren (8,9) bestimmt werden kann.

13. Verfahren zur Positionierung eines aktiv schwingungsisoliert gelagerten Bauteils nach dem vorstehenden Anspruch, **dadurch gekennzeichnet, dass** die Position des Bauteils nach einem Austausch eines Positionssensors (8,9) über den weiteren Positionssensor (10) bestimmt wird.

14. Verfahren zur Positionierung eines aktiv schwingungsisoliert gelagerten Bauteils nach dem vorstehenden Anspruch, **dadurch gekennzeichnet, dass** der ausgetauschte Positionssensor mittels des weiteren Positionssensors (10) kalibriert wird.

15. Verfahren zur Positionierung eines aktiv schwingungsisoliert gelagerten Bauteils nach dem vorstehenden Anspruch, **dadurch gekennzeichnet, dass** der weitere Positionssensor (10) zumindest in einer zur einer Haupterstreckungsrichtung des Bauteils senkrechten Richtung wirksam ist.
